# EUROPEAN PATENT SPECIFICATION

(11) **EP 4 209 000 B1**
(45) Date of publication and mention of the grant of the patent: **22.10.2025**
(21) Application number: 21864866.5
(22) Date of filing: 26.07.2021
(51) Int. Cl.: H10F 39/12, G01T 1/24

(54) **HIGH-DQE DIRECT DETECTION IMAGE SENSOR FOR ELECTRONS WITH 40 - 120 KEV ENERGY**
HOCH-DQE DIREKTDETEKTIONSBILDSENSOR FÜR ELEKTRONEN MIT 40- 120KV-ENERGIE
CAPTEUR D'IMAGE PAR DÉTECTION DIRECTE À HAUTE DQE D'ÉLECTRONS AYANT UNE ÉNERGIE DE 40 À 120 KEV

(30) Priority: 02.09.2020 US 202063073719 P
(43) Date of publication of application: 12.07.2023
(73) Proprietor: Direct Electron, LP, San Diego, CA 92128 (US)
(72) Inventor: BAMMES, Benjamin, San Diego, California 92128 (US); BILHORN, Robert, San Diego, California 92128 (US)
(74) Representative: Maiwald GmbH
(86) International application number: PCT/US2021/043156
(87) International publication number: WO 2022/051040

(56) References cited:
- WO-A1-2011/109425
- US-A1- 2006 169 901
- US-A1- 2012 313 155
- US-A1- 2018 240 842
- US-A1- 2019 140 002
- US-A1- 2019 172 860

## Description

### CROSS-REFERENCE TO RELATED APPLICATION

This application claims benefit to U.S. Provisional Application No. 63/073,719, filed September 2, 2020.

### FIELD

The present disclosure relates to a direct detection sensor and camera system for high detective quantum efficiency (high-DQE) imaging of electrons with energy ranging from 3 keV to 300 keV, and more specifically electrons ranging from 40 keV to 120 keV.

### BACKGROUND

Devices currently used for forming images by detecting electrons in the electron microscope do not provide high spatial resolution and sensitivity in the energy range of 40 keV to 120 keV. Direct Detection Devices (DDD^{®}) and other detectors that detect electrons without the use of intervening scintillators work well at energies above 120 keV. These systems achieve detective quantum efficiency (DQE), which is a measure of sensitivity and resolution, near theoretical limits by using electron counting. Alternatively, detectors using scintillators suffer from resolution-limiting blur and diffuse scattering of light, resulting in a limited DQE. However, because direct detectors perform poorly at low energies, detection of <120 keV electrons has so far relied on scintillator-based detectors.

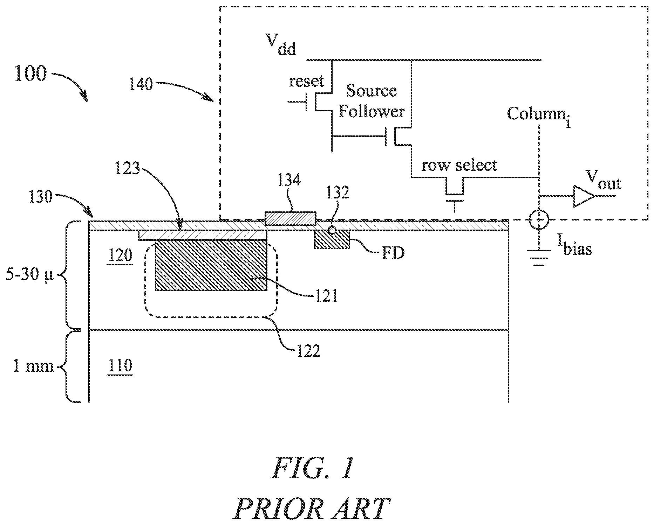

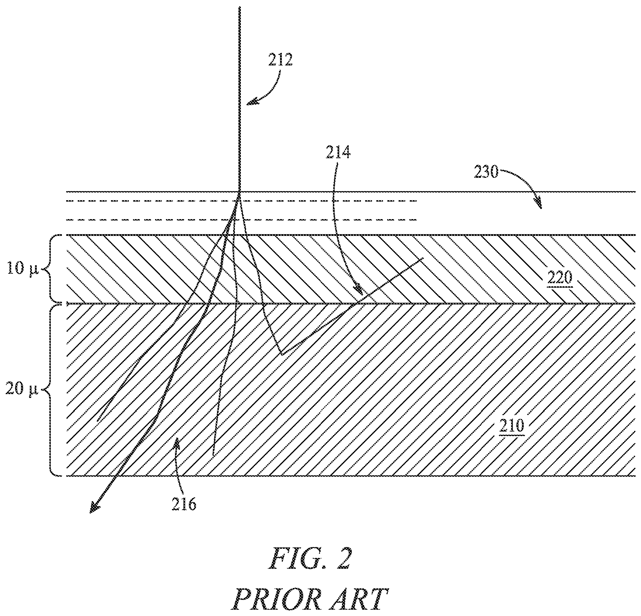

Two types of detector technology are used for the direct detection of electrons in microscopy. The first enjoys wide adoption and is used almost exclusively in biological applications where specimens are held at cryogenic temperatures while imaging (cryo-EM). These are monolithic active pixel sensors (MAPS) produced using complementary metal oxide semiconductor (CMOS) image sensor manufacturing processes. A schematic crosssection of such a sensor is shown schematically in Fig. 1. These sensors are built on an approximately 1 mm thick silicon wafer 110 upon which is grown a lightly doped epitaxial p-type silicon layer (epi) 120 of 5 µm - 30 µm thickness. The circuitry 130 is then built on or built within the epi layer 120 using CMOS image sensor manufacturing processes. An n-type photodiode 121 is formed in a depletion region 122 and topped by a p⁺⁺ pinned layer 123. The epitaxial material is p-type silicon. The substrate 110 is a p⁺ type silicon substrate. A floating diffusion region, FD, is an n-type region. The photodiode acts like a source and the floating diffusion acts like a drain of a MOS transistor. A metallization pattern forms a source contact to the p⁺⁺ region of the photodiode, a drain contact 132 to the floating diffusion region and a transfer gate 134 contact. Electrons interact with the silicon as they penetrate the device, producing signal charge that is collected and read out by read out circuitry 140. As shown in Fig. 2, each incident electron 212 produces many secondary electrons 216 in a cloud trail as they traverse and scatter through the detector. Interactions in the epi layer 220 are the ones of interest as they produce the charge that is collected. Some fraction of incident electrons can undergo scattering at large angles either within the epi layer or material under the epi layer-which is called backscattering-and as a result deposit secondary charge in locations far from their point of entry (as shown by backscattered electron 214, Fig. 2) thereby degrading image quality. To minimize this effect some fraction of the substrate wafer may be removed to reduce the amount of backscattering as shown in Fig. 2. In Fig. 2, the epi layer 220 has been manufactured to be approximately 10 µm thick and the substrate layer has been thinned from approximately 1 mm to approximately 20 µm in thickness. The incident electron energy is 300 keV.

MAPS detectors work very well at electron energies at 200 keV and above, achieving near-ideal DQE. High-energy primary electrons generate a relatively small and localized cloud of secondary electrons as they pass through the detector's epi layer. The limited size of the secondary electron cloud ensures that the signal from each primary electron does not spread over many pixels. Additionally, the high-energy primary electron is unlikely to scatter at high angles in subsequent material, so that backscattering is minimized, provided that the detector is sufficiently thin.

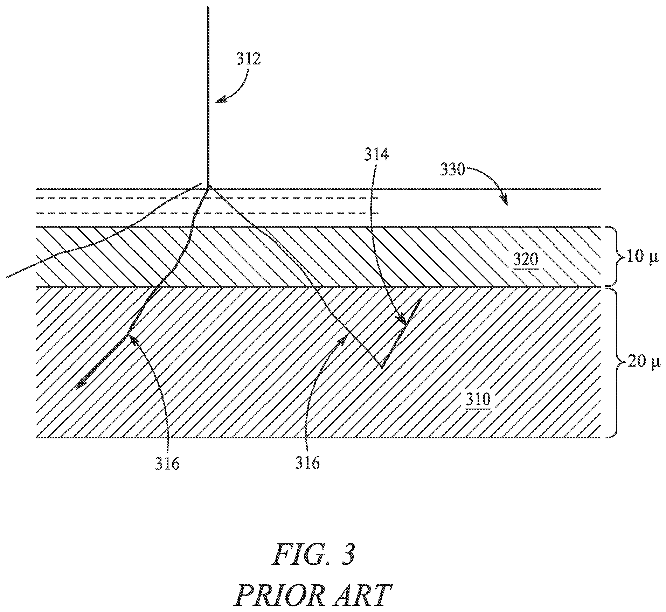

However, the performance of MAPS detectors falls off dramatically at lower electron energies because of increased electron scattering at lower energy as shown in Fig. 3. where the primary electron energy is 100 keV. This low energy causes three problems. First, low-energy primary electrons 312 tend to generate many secondary electrons in the epi layer 320, causing pixels to saturate with fewer primary electrons. Second, low-energy primary electrons and their resulting secondary electron cloud trail 316 tend to scatter across many pixels. causing the point-spread function of the detector to expand and reducing the resolution of the detector, as shown by comparing the size of the interaction volume in Fig. 3 to that shown in Fig. 2. Third, low-energy primary electrons tend to scatter at high angles upon interaction with any material under the epi layer, resulting in a greater number of backscattered electrons 314. These backscattered electrons 314 cause detection of secondary events far from the original point of incidence of the primary electrons. Backscattering both reduces resolution, as measured by the modulation transfer function (MTF), and increases noise by adding extra false positives.

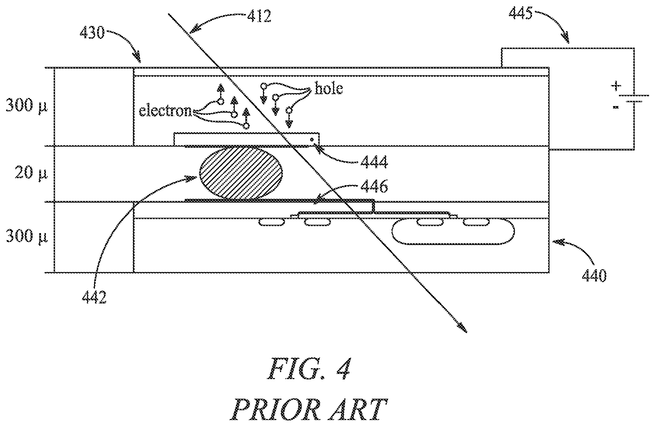

A second type of detector used for directly detecting electrons in the electron microscope is the hybrid pixel detector (HPD) shown in Fig. 4. The hybrid pixel detector provides for electron imaging in the electron energy range of interest, at high-DQE. These devices are a hybridization between an aluminum detector layer 430 that absorbs the primary electron to produce a cloud of secondary electrons and a readout circuitry layer 440 that reads out the number and locations of interactions. The two layers are electrically connected to each other through a process called bump bonding involving indium or similar metal "bumps" 442 that create connections between the detector layer 430 and readout pixels 446. A voltage 445 is applied between the aluminum detector layer 430 and the p-type silicon layer 444. As shown in Fig. 4. a p-type silicon layer 444 captures the electron/hole disturbances generated by the impinging primary electron beam 412 and an electric current is conveyed through the solder bump 442 to the read-out circuitry layer 440. Unlike modern MAPS detectors used in electron microscopy that allow primary electrons to pass completely through the sensitive volume, HPDs strive to stop the primary electron in a relatively thicker detector layer. Note the dimensions of the layers in these detectors are generally about 10 times larger than for MAPS detectors.

Hybrid pixel detectors work best at lower electron energies (i.e., 120 keV or less) where the incident electron can be stopped in the detector layer, but their performance deteriorates as the energy is increased because of the increasing volume of the secondary charge cloud and the possibility that primary electrons will completely penetrate the detecting layer before being stopped, thereby depositing less than their full energy. There have been some efforts recently to increase the performance of HPDs for high energy electrons (i.e., 200 keV or more) by using higher-Z materials (higher atomic number, e.g., germanium (Ge), gallium arsenide (GaAs), cadmium telluride (CdTe), and cadmium zinc telluride (CZT)) besides silicon for the detecting layer.

There are two significant limitations of HPDs, which limit their usefulness for imaging methods such as cryo-EM. First, it is difficult in these sensors to account for detection events that spread over multiple pixels. The use of large (i.e., >50 µm wide) pixels reduces the likelihood that a primary electron will deposit energy over multiple pixels, but it remains possible, especially when the primary electron interacts with the sensor near the border between two pixels. Large pixels are also necessary in HPDs to accommodate the space required by the readout circuitry. Second, the use of large pixels in HPDs severely limits the overall size of the pixel array (total number of pixels). Large arrays of HPDs require tiling smaller devices and at some point, the arrays grow too large to be practical for electron microscopy. Current generation HPDs are limited to about 0.5 megapixels - 1.0 megapixels, while MAPs detectors achieve sizes up to 67 megapixels.

MAPS sensors used at 200 keV and 300 keV have been tested at lower energies but DQE is not sufficiently high. The same is true for scintillator-coupled CCD and CMOS systems. HPDs have shown promise at the energy range of interest but because of their pixel size, arrays on the order of 100 mm on a side would be necessary to provide a 4 megapixel field-of-view, which is not practical both due to space constraints on electron microscopes and manufacturing cost.

Despite the lack of high-quality detectors, there is significant interest in operating electron microscopes within the range of 60 kV to 120 kV for studies in both the life and materials sciences.

Back side illumination of an electron microscope detector has been used without removal of the substrate. For example, a series of lens electrodes or a scintillator were used to decelerate the electrons before they reached the substrate. (*See. e.g..* U.S. Patent App. Pub. No. 2010/0123082A1).

For example, in materials science, the use of low energy electrons limits knock-on damage and allows for effective study of the structure of graphene. (*See* Bachmatiuk A, Zhao J, Gorantla SM, Martinez IGG, Wiedermann J, Lee C, Eckert J, Rummeli MH, "Low voltage transmission electron microscopy of graphene". Small 11(5): 515-42 (2015).)

In life science, there is a growing push for effective low-cost 100 kV cryo-EM instruments. A peer-reviewed paper by Nobel laureate Richard Henderson was recently published to demonstrate the high-resolution potential of such a system. However, this paper concluded that, "Currently, the lack of a suitable high-speed, high-efficiency detector with a large number of pixels (>4 × 10⁶) is the primary limitation both to the ultimate achievable resolution and to the practical use of a 100 keV transmission electron microscope for cryoEM." (*See* Naydenova K. McMullan G, Peet MJ, Lee Y. Edwards PC. Chen S, Leahy E. Scotcher S, Henderson R, & Russo CJ, "CryoEM at 100 keV: a demonstration and prospects", IUCrJ 6(6): 1086-1098 (2019), and Hand E. "We need a people's cryo-EM. Scientists hope to bring revolutionary microscope to the masses", Science (2020), available at www.sciencemag.org A direct detector for imaging ionizing radiation according to the prior-art is shown in document US 2019/172860A1.

Accordingly, it is an object of the present disclosure to provide a device, system and method for a direct detection sensor and camera system for high-DQE imaging of electrons with energy ranging from 3 keV to 300 keV, and more specifically electrons ranging from 40 keV to 120 keV to fill the need for a high-speed, high efficiency detector with a large number of pixels and high image resolution.

### SUMMARY

The present disclosure describes a direct detection sensor and camera system for high-DQE imaging of electrons with energy ranging from 3 keV to 300 keV, and more specifically for electrons ranging from 40 keV to 120 keV. A camera is provided that can image electrons in the electron microscope at high resolution and with a large field of view at electron beam energies that are scientifically interesting but that were difficult to use previously. The system also represents an approach that is practical to manufacture at volume and modest cost.

According to an embodiment, a method of forming a direct detector for imaging ionizing radiation in a transmission electron microscope is described, comprising forming a monolithic active pixel sensor in a CMOS image sensor process, wherein the sensor includes an epitaxial silicon layer disposed on a silicon substrate and a CMOS layer disposed on the epitaxial silicon layer, bonding a handling wafer material to the front side of the CMOS layer, removing the silicon substrate to reveal a back side of the epitaxial silicon layer, selectively removing a first section of the handling wafer material from a sensing region of the CMOS layer and leaving a second section of the handling wafer material around the periphery of the sensing region, wherein the direct detector is configured to be mounted in the transmission electron microscope by contacting only the second section, and wherein the direct detector is further configured such that the ionizing radiation enters from only the back side of the epitaxial silicon layer.

According to another embodiment, direct detector for imaging ionizing radiation is described, the detector comprising a monolithic active pixel sensor including an epitaxial silicon layer disposed on a silicon substrate and a CMOS layer disposed on the epitaxial silicon layer, a handling wafer bonded to a front side of the CMOS layer, wherein the substrate has been removed down to a back side of the epitaxial silicon layer and wherein a first section of the handling wafer has been selectively removed from a region corresponding to the pixel sensor leaving a second section of the handling wafer at the periphery of the sensor.

According to an embodiment a method of ionizing radiation in a transmission electron microscope, comprising providing a monolithic active pixel sensor which includes an epitaxial layer disposed between a CMOS layer and a silicon substrate, wherein providing the monolithic active detector includes: planarizing a front side of the CMOS layer, bonding a handling wafer to a front side of the CMOS layer, removing the silicon substrate to reveal a back side of the epitaxial silicon layer, selectively removing a first section of the handling wafer from a sensing region of the CMOS layer and leaving a second section of the handling wafer around the periphery of the sensing region, mounting the detector in the transmission electron microscope, orienting the detector so that the ionizing radiation enters the detector from the back side of the epitaxial silicon layer, and reading out signals representing the ionizing radiation.

The foregoing paragraphs have been provided by way of general introduction, and are not intended to limit the scope of the following claims. The described embodiments, together with further advantages, will be best understood by reference to the following detailed description taken in conjunction with the accompanying drawings.

### BRIEF DESCRIPTION OF THE DRAWINGS

A more complete appreciation of the invention and many of the attendant advantages thereof will be readily obtained as the same becomes better understood by reference to the following detailed description when considered in connection with the accompanying drawings, wherein:
Fig. 1 is a schematic cross section of a monolithic active pixel sensor;
Fig. 2 is a thinned MAPS sensor showing the charge cloud produced by an incident primary electron;
Figs. 3 illustrates the primary electron energy level effect on the secondary electron cloud size at 100 keV,
Fig. 4 illustrates a schematic cross section of a hybrid pixel detector;
Fig. 5 illustrates an electron detector fabricated in the epi layer of a silicon wafer:
Fig. 6 illustrates a silicon handling wafer bonded over the electron detector;
Fig. 7 illustrates the electron detector following removal of the original substrate silicon leaving the back surface of the epi layer exposed and the handling wafer providing mechanical support;
Fig. 8 illustrates the electron detector following selective removal of handling wafer material;
Fig. 9 illustrates the electron detector back side orientation relative to a primary electron beam;
Figs. 10A-10B illustrate an image of a beamstop with the selected area (SA) aperture inserted on a TEM operating at 100 kV in electron counting mode: "A" for the entire image, and "B" for a zoomed in view of the end of the beamstop:
Fig. 11A is a graph illustrating the MTF and DQE of the prototype sensor for 100 kV cryo-EM.
Fig. 11B is a graph comparing the DQE of the prototype sensor at 100 kV to a conventional sensor at 300 kV;
Fig. 12A illustrates a resolution assessment at 100 kV of the prototype sensor showing the Thon rings at 3.5 Angstroms:
Fig. 12B illustrates the Fourier transform of an image of a line grating replica grid collected under low-dose cryo-EM conditions in electron counting mode on the prototype sensor;
Fig. 13A illustrates a cryo-EM micrograph of mouse heavy chain apoferritin collected at 100 kV by the prototype sensor showing a cropped region from the final image,
Fig. 13B illustrates the Fourier transform of the image of Fig. 13A: and
Fig. 13C illustrates rotationally-averaged power spectrum showing Thon rings out to about 4 Å resolution.

### DETAILED DESCRIPTION

The terms "a" or "an", as used herein, are defined as one or more than one. The term "plurality", as used herein, is defined as two or more than two. The term "another", as used herein, is defined as at least a second or more. The terms "including" and/or "having", as used herein, are defined as comprising (i.e., open language). Reference throughout this document to "one embodiment", "certain embodiments", "an embodiment", "an implementation", "an example" or similar terms means that a particular feature, structure, or characteristic described in connection with the embodiment is included in at least one embodiment of the present disclosure. Thus, the appearances of such phrases or in various places throughout this specification are not necessarily all referring to the same embodiment. Furthermore, the particular features, structures, or characteristics may be combined in any suitable manner in one or more embodiments without limitation.

The sensitive layer in the detector of the present disclosure remains near the top surface (because it is a back side illumination (BSI) MAPS device), therefore the sensor performs well for lower-energy electrons (i.e., 1 keV - 60 keV), and because the sensor is sufficiently thin, it also performs well for higher-energy electrons (i.e., 120 keV - 300 keV). Therefore, for the first time, a MAPS detector sensitive to the entire range of electron energies typically used in electron microscopy is described.

Back-thinning and back side illumination have been used for visible and ultraviolet photon detection, and thinned and back side illuminated MAPS sensors for detection of electrons below about 25 keV in energy have been tested. These sensors do not require removal of handling wafer material since the primary beam electrons do not penetrate beyond the epi layer thickness. However, these sensors do not work well at higher electron energies because of backscattering from the handling wafer material.

High-DQE is important in an electron detector to for use in electron microscopy. Current scintillator-coupled CCD or CMOS sensors and current direct detection MAPS sensors do not provide sufficient DQE.

Other requirements for detecting electrons in an electron microscope are for a large field-of-view with at least 4 megapixels, which is a physical size compatible with current microscope designs. Another concern is to minimize conversion costs and total cost of ownership (TCO). Although HPD sensors offer high-DQE. they cannot practically satisfy these other requirements because of the large pixels necessary in these devices. Large devices have several disadvantages, the two most important being that they do not easily fit in microscopes as they are currently designed, and they are more expensive. Two factors drive cost: first, fewer devices fit on a silicon wafer, and second, the yield per device drops as area goes up. The hybridization step also adds cost.

The present disclosure describes a monolithic active pixel sensor fabricated in epi silicon from which all or essentially all of the substrate silicon has been removed and which is oriented in the electron beam such that primary beam electrons are incident on the epi-vacuum interface.

The device fabrication is described below.

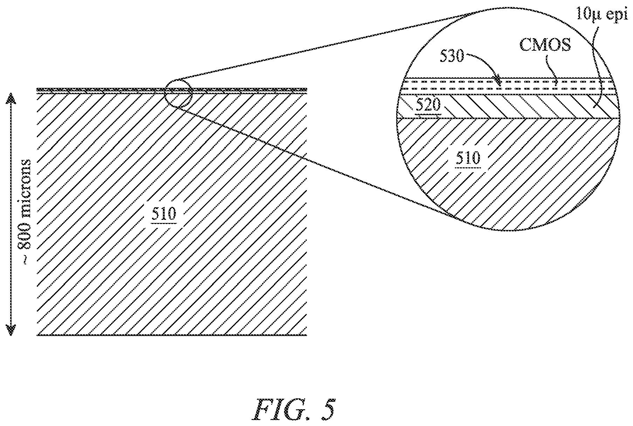

Fig. 5 shows fabrication of the monolithic active pixel sensor on a standard epi wafer as would typically be used in a CMOS image sensor process. A CMOS circuitry layer 530, 10 µm epitaxial layer 520 and substrate layer 510 are shown in the inset for clarity.

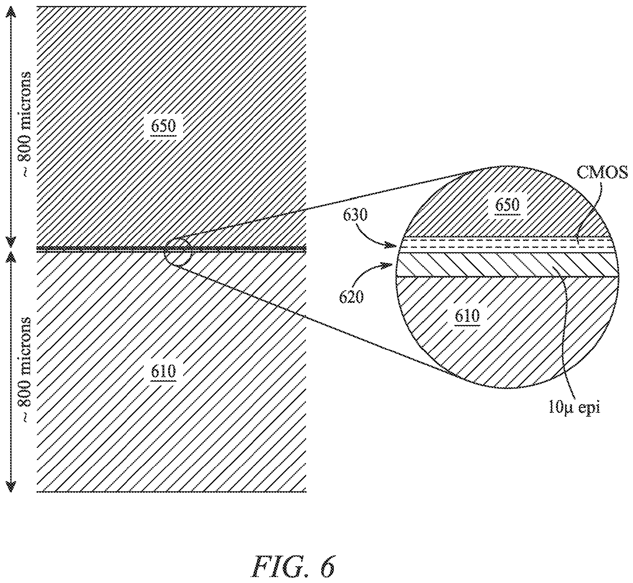

Following device fabrication, the top CMOS surface is planarized and then subsequently bonded to a secondary handling wafer 650 as shown in Fig. 6. A bond such as an oxide-oxide bond may be used. The CMOS layer 630, 10 µm epitaxial layer 620 and substrate layer 610 remain in place, as shown in the inset.

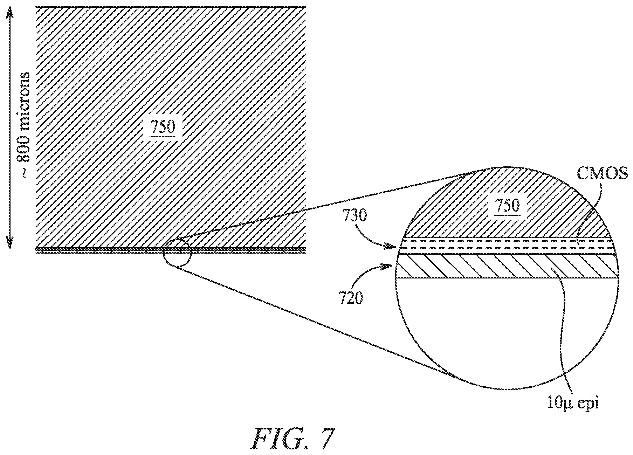

Once the handle wafer is in place, the substrate silicon is either partially or completely removed down to the epi-substrate junction or thereabouts using a process such as grinding followed by chemical-mechanical polish and/or chemical etching, resulting in the structure shown in Fig. 7, for example. The inset shows that the substrate layer has been removed, leaving the handling layer 750, the CMOS layer 730 and the 10 µm epitaxial layer 720. In some cases, a thin passivation layer may be added to the surface after removal of the substrate silicon.

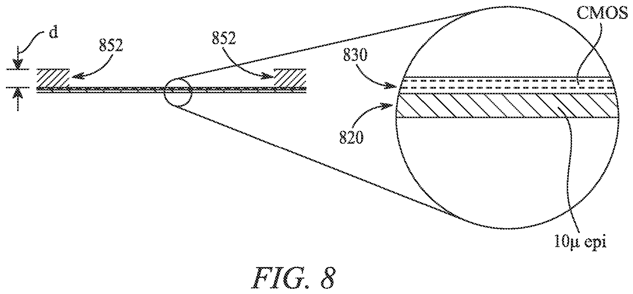

Fig. 8 shows the next step, in which the handling wafer is selectively removed from the area adjacent to the array of pixels leaving material 852 at the device periphery for strength. The thickness of material 852 is shown as *d*, which may be any thickness in the range of 1 microns to 800 microns. A process such as grinding followed by selective chemical etch may be used. The handle wafer may be completely removed from behind the pixel array, as shown in the inset showing the CMOS layer 830 and the 10 µm epitaxial layer 820, or some material may be left behind to provide additional rigidity. A tradeoff between mechanical strength and the degree of electron backscattering is made.

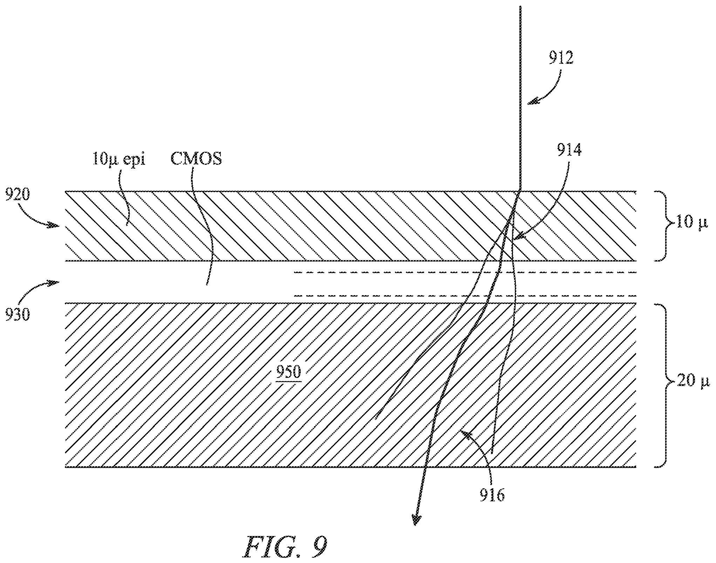

The device is mounted by attaching the mounting structure to the remaining handle wafer material along the periphery and then installed in a camera system so that primary beam electrons 912 enter the device from the side with the exposed epi layer 920 as shown in Fig. 9. The secondary electrons generated in the epi layer 920 form a tight grouping as they enter the CMOS circuitry layer 930. Backscattered electrons 916 in the 0 - ~20 µm thick handling wafer 950 pass out of the device without being picked up by a photodiode.

The present disclosure uses a MAPS detector with back side illumination (BSI) once the substrate is removed combined with handling wafer removal from behind the active area to significantly reduce backscattering. This is the first known implementation of handling wafer removal behind a BSI MAPS device for the detection of electrons.

Conventional MAPS detectors for electron microscopy use front side illumination (FSI) with some of the substrate material removed to reduce backscattering. These conventional detectors are on the order of 30 µm thick. The BSI MAPS detector of the present disclosure provides for high resolution low-energy (<120 keV) electron imaging with a decreased thickness of about 10 µm to about 30 µm.

HPDs have also been proposed for detection of 40 keV - 120 keV electrons. In these detectors, electrons enter the detection layer which is designed to be thick enough to absorb them. Photogenerated electron-hole pairs are separated by an applied electric field and the resulting current pulses are detected by an adjacent bump-bonded readout CMOS circuit. This is distinct from the architecture of MAPS detectors, which are monolithic, and generally require incident electrons to pass through the sensor without being completed absorbed.

Referring again to Fig. 2 and Fig. 9. microscope electrons (212. 912) can enter the device from either the front side through CMOS layer 230 or the back side 920. The electrons interact with the silicon in the epitaxial silicon area 920 and generate conduction band electrons. Unlike photons, the microscope electrons carry much more energy and generate many conduction band electrons for each incident electron. The number of conduction band electrons generated depends on many factors including the incident energy of the system (e.g., microscope electrons).

FSI of MAPS detectors results in too much electron scattering and backscattering to yield high-DQE once primary beam energy drops below ~200 keV. BSI and handling wafer removal are used to form the detector of the present disclosure which achieves high-DQE. Mechanical integrity is maintained by using a selective handling wafer removal technique that leaves material in the non-image forming area of the device. The device is mounted and cooled through this more robust peripheral area. The detector of the present disclosure has a high pixel density resulting in a practical way to achieve a large field-of-view for imaging at 40 keV - 120 keV with high-DQE and has manufacturing costs similar to MAPS detectors currently used at higher primary beam energies.

Additionally, because the sensitive layer in the detector of the present disclosure remains near the top surface (because it is a BSI MAPS device), the sensor performs well for lower-energy electrons (i.e., 1 keV - 60 keV), and because the sensor is sufficiently thin, it also performs well for higher-energy electrons (i.e., 60 keV - 300 keV). Therefore, for the first time, a MAPS detector sensitive to the entire range of electron energies typically used in electron microscopy is described.

Finally, compared to HPDs, the small pixels of the detector of the present disclosure enable large pixel arrays within the space constraints of an electron microscope and minimize manufacturing costs, as multiple devices can be formed on a single silicon wafer.

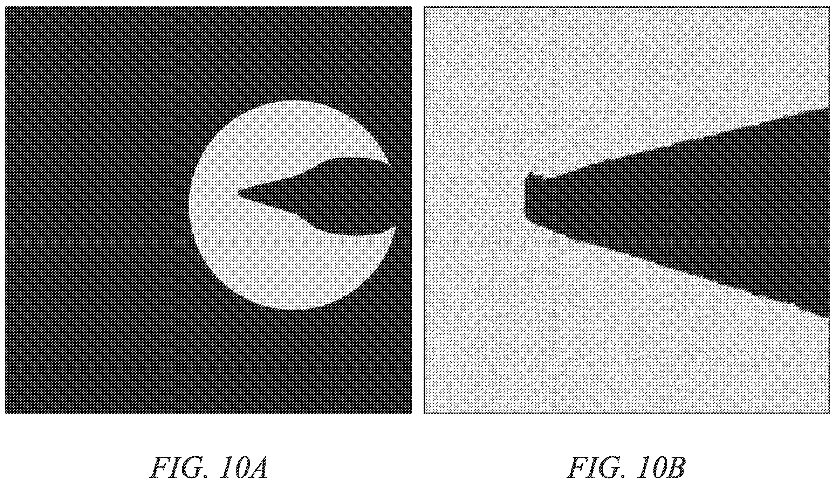

Two of the most significant problems with conventional direct detection sensors at 100 kV have been (1) poor resolution due to increased scattering of 100 kV primary electrons within the sensitive layer of the sensor, and (2) high background noise due to backscattering of 100 keV primary electrons. A 100 kV camera was installed on a Thermo Fisher Talos TEM equipped with a field-emission gun and aligned for 100 kV operation to test the detector. Fig. 10A shows an image of a selected area (SA) aperture of a beamstop detected by the detector of the present disclosure installed on the Thermo Fisher Talos TEM operating at 100 kV. This image has sharp edges (no noticeable blurring at the edges of the beamstop) and only 0.05% backscattering (based on the relative number of counts under the beamstop, which could only be present due to backscattering). Fig. 10B is a zoomed-in view of the end of the beamstop.

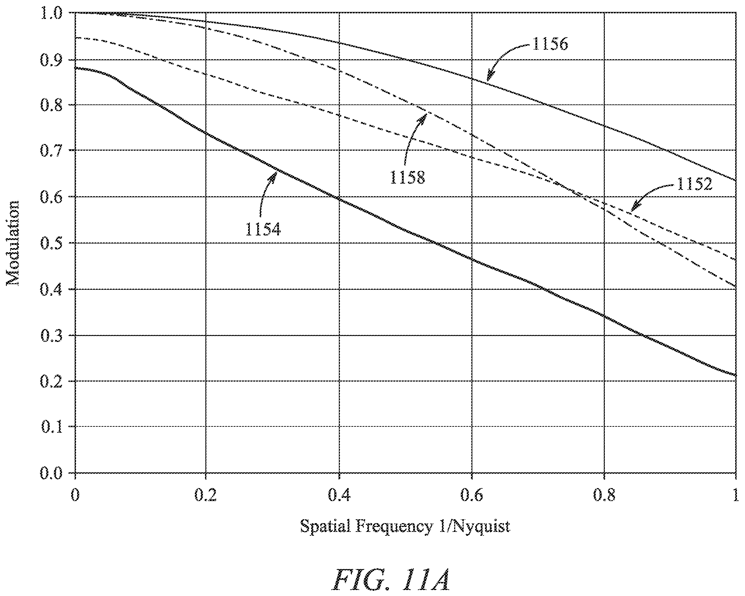

In order to generate a quantitative assessment, the MTF 1152 and the DQE 1154 of the prototype detector were calculated (Fig. 11A). The theoretical maximum MTF 1156 and theoretical maximum DQE 1158 are also plotted to compare the close response of the detector to the theoretical curves.

The MTF of a detector is a measurement of its ability to transfer contrast at a particular resolution from the object to the image, that is, the MTF determines how much contrast in the original object is maintained by the detector. In practice, the MTF is determined acquiring one or more images of straight ("knife") edges on the detector, calculating the line-spread function (that is, the amount of blurring at the edge in the image) and converting the calculated real space line-spread function to frequency-space using a Fourier transform. The MTF is graphed as normalized modulation versus the spatial frequency at the inverse Nyquist limit. By definition, the value of the MTF at zero spatial frequency is unity but in the presence of long range scattering within the detector this can fall rapidly with increasing spatial frequency.

The MTF was calculated using eight images of a beamstop inserted, then collected in electron counting mode with a total detected exposure of 52.3 electrons per pixel spread over 5017 raw frames (resulting in an exposure rate per frame of 0.01 electrons per pixel per frame). Each image was processed independently (*See. e.g*., Ruskin, Yu, & Grigorieff, J Struct Biol 184: 385-393 (2013), "FindDQE v.1.06") and then the resulting MTF curves were averaged to generate the final MTF curve.

The DQE is defined as the ratio of the square of the output signal to noise ratio (S/N)ₒᵤₜ to the square of the input signal-to-noise ratio (S/N)ᵢₙ, and provides a measure of the quality with which incident electrons are recorded. A perfect detector has a DQE of unity at zero spatial frequency (DQI(0)) and to achieve this all incident electrons must be detected with equal weight. The DQE of real detectors is always smaller than unity reflecting the fact that in practice incident electrons are recorded with different weights. (DQE(0)) was calculated in several steps.

First, a histogram was plotted of the total integrated intensity of each detected event from raw integrating-mode frames collected of an empty specimen area. A total of 3,664,451 events were analyzed from a 256 x 256 region of interest in the middle of sensor. The histogram was fit to a Landau distribution using a curve fit function. (*See, e.g..* Landau, J Phys USSR 8: 201 (1944); scipy.optimize.curve_fit function. SciPy.org. Release 1.52, July 23, 2020. available at does.scipy.org). The fraction of incident electron missed by the detector was estimated using the integrated area under the fit Landau curve to be less than the counting threshold of the detector. This implied that 2.69% of incident electrons were missed by the detector, as this fraction of electrons deposited too little energy in the sensitive layer of the sensor and thus were below the noise level of the sensor. Therefore, the fit Landau curve implies that 97.3% of incident 100 keV electrons were detected by the sensor.

Second, the total number of detected events under a beamstop was compared to an illuminated area of the sensor. To reduce diffuse scattering on peripheral TEM and camera equipment, this data was collected with the SA aperture of the TEM inserted such that the illuminated area was smaller than the sensor. A 256 x 256 region under the beamstop had 1,981 detected events, whereas a 256 x 256 region in the illuminated area in the same data had 3,664,451 detected events. The ratio of these values implies that 0.054% of 100 keV primary electrons are backscattered within the camera, generating a false second detection.

The detected exposure rate on the sensor was therefore adjusted by dividing by 97.3% and multiplying by [100% - 0.054%] to account for missed and backscattered electrons, respectively. The final calibrated exposure rate was 53.7 electrons per pixel per frame.

Finally, the DQE(0) was calculated using a noise binning method. (*See. e.g*., McMullan, Chen, Henderson, & Faruqi, Ultramicroscopy 109: 1126-1143 (2009)).

The final DQE curve was calculated by multiplying DQE(0) by MTF squared. Note that the noise power spectrum (NPS) has no impact, since it is unity for all spatial frequencies for electron counting MAPS detectors in the absence of coincidence loss. (*See, e.g.,* Li, Zheng, Egami, Agard, & Cheng, J Struct Biol 184: 251-260 (2013)).

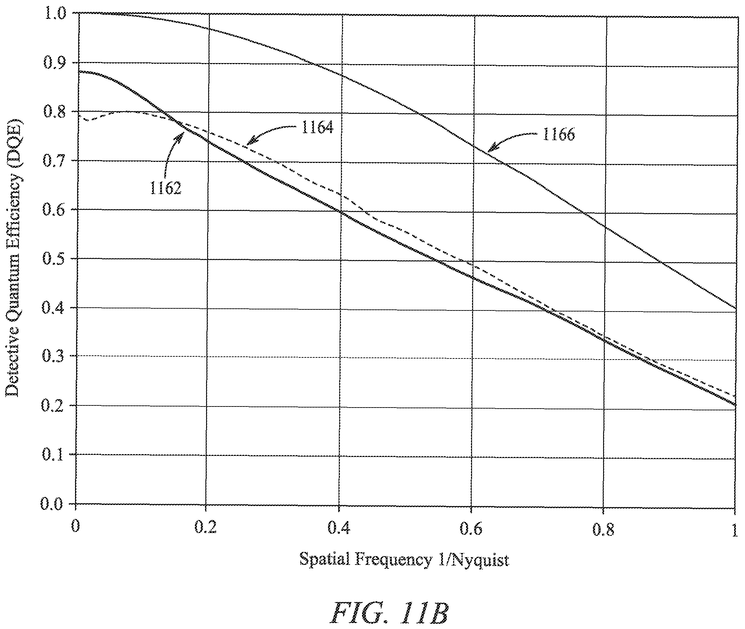

Fig. 11B shows that the performance of the prototype sensor for a 100 kV (line 1162) cryo-EM closely matches the performance of a conventional detector (Gatan K2-Summit) at 300 kV, with respect to the maximum DQE (line 1166) The DQE of the conventional detector at 300 kV (line 1164) was taken from McMullan, Faruqi, Clare. & Henderson. Ultramicroscopy 147: 156-163 (2014). This result clearly demonstrates the high performance of the prototype sensor at 100 kV.

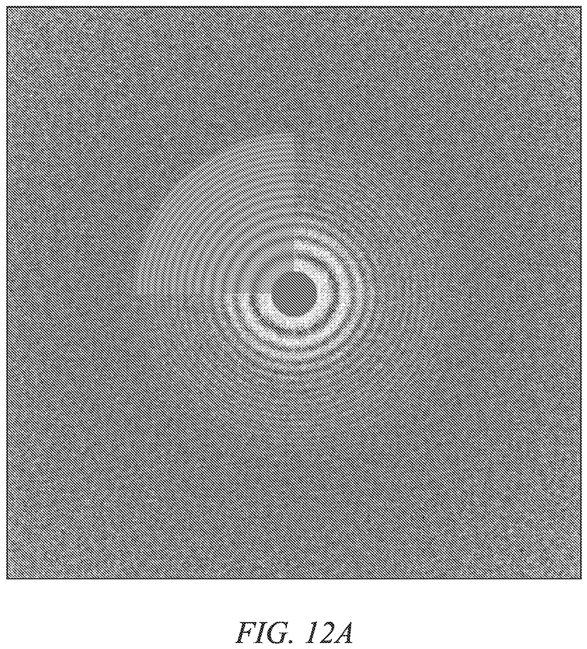

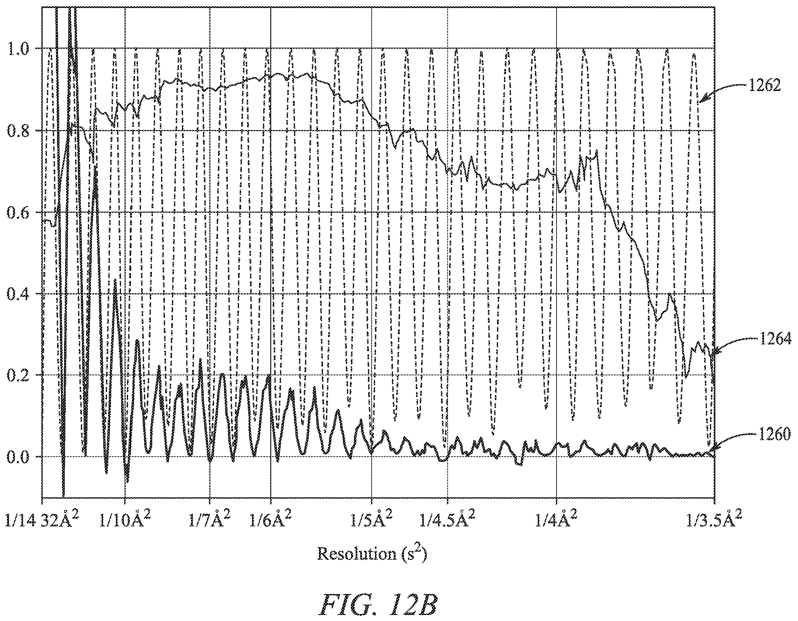

The contrast transfer function (CTF) is a mathematical description of the imaging process in the TEM expressed in Fourier space. Images of carbon film under low-dose cryo-EM conditions at 100 kV using the prototype sensor show Thon rings at up to about 3.5 Angstroms resolution are shown in Fig. 12A. The Fourier transform of the detected power spectra 1260 is compared to the CTF model 1262, and the quality of the fit 1264 is shown in Fig. 12B.

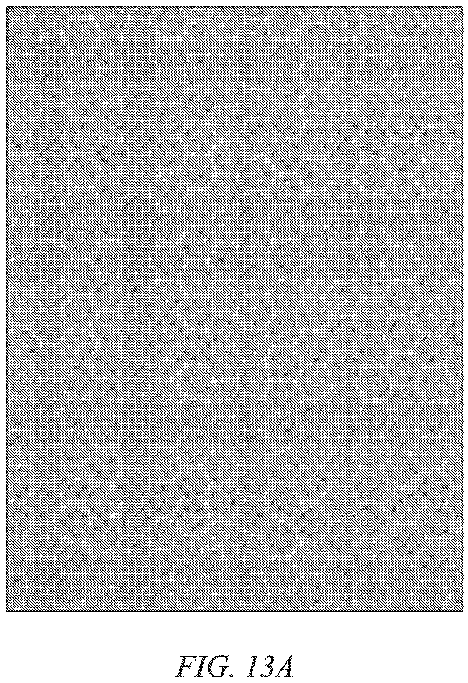

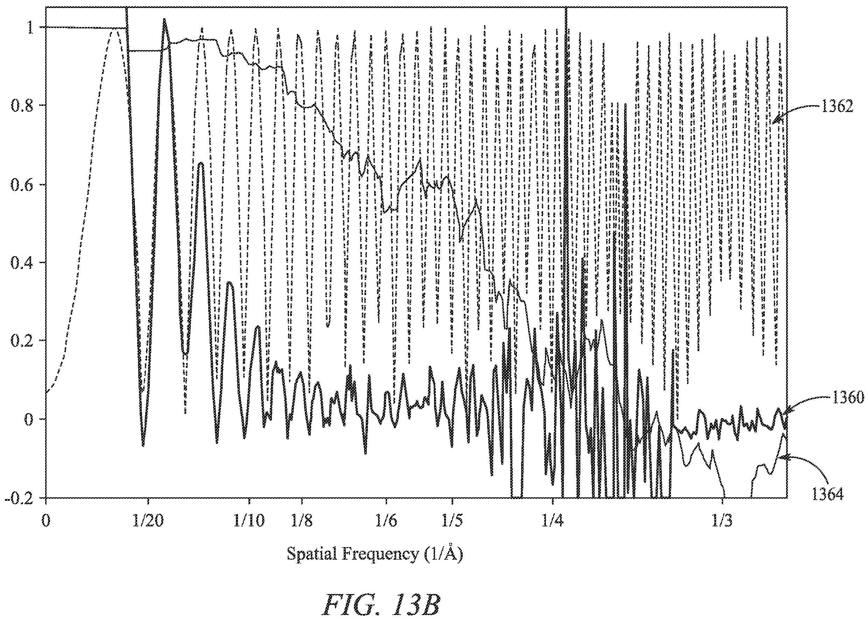

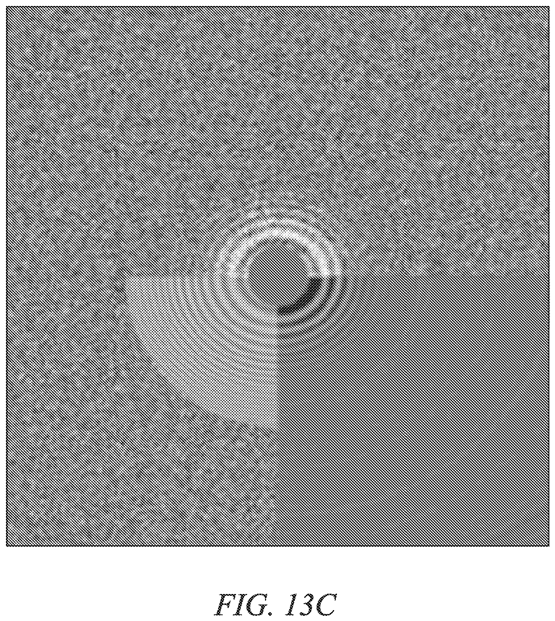

Fig. 13A shows that images of frozen-hydrated apoferritin (a standard cryo-EM specimen) exhibit high contrast and high resolution, as expected from the DQE curves. The nominal magnification of the microscope was 73,000 times, yielding sampling of 1.37 Å/pixel. The total exposure was about 40 e-/Å2. Fig. 13B shows the Fourier transform of the detected power spectra 1360 as compared to the CTF model 1362. The quality of the fit 1364 is shown. Fig. 13C illustrates the rotationally averaged power spectrum showing Thon rings out to about 4 resolution.

## Claims

1. A method of forming a direct detector for imaging ionizing radiation in a transmission electron microscope, comprising:
forming a monolithic active pixel sensor in a CMOS image sensor process, wherein the sensor includes an epitaxial silicon layer (520) disposed on a silicon substrate (510) and a CMOS layer (530) disposed on the epitaxial silicon layer;
bonding a handling wafer material to a front side of the CMOS layer (650); and
removing the silicon substrate to reveal a back side of the epitaxial silicon layer;
**characterized by**
selectively removing a first section of the handling wafer material from a sensing region of the CMOS layer and leaving a second section (852) of the handling wafer material around a periphery of the sensing region,
wherein the direct detector is configured to be mounted in the transmission electron microscope by contacting only the second section, and
wherein the direct detector is further configured such that the ionizing radiation enters from only the back side of the epitaxial silicon layer.

2. The method of claim 1, further comprising:
removing a first portion of the silicon substrate by a grinding process; and
removing a remaining portion of the silicon substrate by chemical etching.

3. The method of claim 1, further comprising:
removing the first section of the handling wafer by selective chemical etching.

4. The method of claim 1, further comprising:
forming a photodiode in the epitaxial silicon layer; and
forming a floating diffusion region in the epitaxial silicon layer.

5. The method of claim 4, further comprising:
forming a metallization pattern on the CMOS layer that includes a photodiode contact, a floating diffusion contact, and a gate contact; and
connecting the floating diffusion contact to a read-out circuit.

6. The method of claim 1,
wherein the method further comprises planarizing the front side of the CMOS layer before the bonding of the handling wafer, or
wherein the bonding of the handling wafer material to the front side of the CMOS layer is by an oxide-to-oxide bond.

7. The method of claim 1, wherein the epitaxial layer is disposed to a thickness of 4 µm to 20 µm.

8. A direct detector for imaging ionizing radiation, the detector comprising:
a monolithic active pixel sensor including an epitaxial silicon layer (920) disposed on a silicon substrate and a CMOS layer (930) disposed on the epitaxial silicon layer; and
a handling wafer (950) bonded to a front side of the CMOS layer,
wherein the silicon substrate has been removed down to a back side of the epitaxial silicon layer,
**characterized in that**
a first section of the handling wafer has been selectively removed from a region corresponding to the pixel sensor leaving a second section of the handling wafer at a periphery of the pixel sensor, and
the direct detector is configured such that the ionizing radiation enters from the back side of the epitaxial silicon layer.

9. The direct detector of claim 8, wherein the epitaxial layer is approximately 4 µm to 20 µm in thickness.

10. The direct detector of claim 8, wherein the monolithic active pixel sensor further includes:
a depletion region in the epitaxial silicon layer,
a photodiode in the depletion region,
a pinned layer on the photodiode, and
a floating diffusion region in the epitaxial silicon layer.

11. The direct detector of claim 10,
wherein the epitaxial layer is a p-type silicon layer,
wherein the photodiode is an n-type photodiode embedded in a depletion region,
wherein the pinned layer is p⁺⁺-type silicon, and
wherein the floating diffusion region is an n-type silicon material.

12. The direct detector of claim 10, wherein the CMOS layer includes:
a metallization pattern on the front side of the CMOS layer, including a photodiode contact, a floating diffusion region contact, and a gate contact, and
a read-out circuit connected to the floating diffusion region contact.

13. The direct detector of claim 8, wherein the direct detector is configured to be mounted in a transmission electron microscope with an orientation such that ionizing radiation enters the detector from the back side of the epitaxial silicon layer.

14. A method of detecting ionizing radiation in a transmission electron microscope, comprising:
providing a monolithic active pixel sensor which includes an epitaxial layer disposed between a CMOS layer and a silicon substrate, the monolithic active detector further including a handling wafer bonded to a front side of the CMOS layer, wherein the silicon substrate has been removed to reveal a back side of the epitaxial silicon layer, and wherein a first section of the handling wafer has been selectively removed from a sensing region of the CMOS layer while leaving a second section of the handling wafer around a periphery of the sensing region, wherein the detector is configured such that the ionizing radiation enters from the back side of the epitaxial silicon layer;
mounting the detector in the transmission electron microscope;
orienting the detector so that the ionizing radiation enters the detector from the back side of the epitaxial silicon layer; and
reading out signals from the detector representing the ionizing radiation.

15. The method of claim 14,
wherein the ionizing radiation is electrons having an energy of 40 keV to 120 keV, or
wherein the ionizing radiation is electrons having an energy of 0 keV to 100 keV, or
wherein the ionizing radiation is electrons having an energy of 0 keV to 300 keV, or
wherein the ionizing radiation is electrons having an energy of 0 keV to 30 keV, or
wherein the ionizing radiation is electrons having an energy of 100 keV.

## Patentansprüche

1. Verfahren zum Bilden eines Direktdetektors zur Bildgebung von ionisierender Strahlung in einem Transmissionselektronenmikroskop, umfassend:
Bilden eines monolithischen aktiven Pixelsensors in einem CMOS-Bildsensorprozess, wobei der Sensor eine epitaxiale Siliziumschicht (520), die auf einem Siliziumsubstrat (510) angeordnet ist, und eine CMOS-Schicht (530), die auf der epitaxialen Siliziumschicht angeordnet ist, aufweist;
Bonden eines Handhabungswafermaterials an eine Vorderseite der CMOS-Schicht (650);
und
Entfernen des Siliziumsubstrats, um eine Rückseite der epitaxialen Siliziumschicht freizulegen;
**gekennzeichnet durch**
selektives Entfernen einer ersten Sektion des Handhabungswafermaterials von einer Sensorregion der CMOS-Schicht und Belassen einer zweiten Sektion (852) des Handhabungswafermaterials um einen Umfangsrand der Sensorregion herum,
wobei der Direktdetektor dazu eingerichtet ist, in dem Transmissionselektronenmikroskop durch Kontaktieren allein der zweiten Sektion montiert zu werden, und
wobei der Direktdetektor des Weiteren so eingerichtet ist, dass die ionisierende Strahlung nur von der Rückseite der epitaxialen Siliziumschicht her eintritt.

2. Verfahren nach Anspruch 1, des Weiteren umfassend:
Entfernen eines ersten Abschnitts des Siliziumsubstrats durch einen Schleifprozess; und
Entfernen eines verbleibenden Abschnitts des Siliziumsubstrats durch chemisches Ätzen.

3. Verfahren nach Anspruch 1, des Weiteren umfassend:
Entfernen der ersten Sektion des Handhabungswafers durch selektives chemisches Ätzen.

4. Verfahren nach Anspruch 1, des Weiteren umfassend:
Bilden einer Fotodiode in der epitaxialen Siliziumschicht; und
Bilden einer potenzialfreien Diffusionsregion in der epitaxialen Siliziumschicht.

5. Verfahren nach Anspruch 4, des Weiteren umfassend:
Bilden einer Metallisierungsstruktur auf der CMOS-Schicht, die einen Fotodiodenkontakt, einen potenzialfreien Diffusionskontakt und einen Gate-Kontakt aufweist; und
Verbinden des potenzialfreien Diffusionskontakts mit einer Ausleseschaltung.

6. Verfahren nach Anspruch 1,
wobei das Verfahren des Weiteren ein Planarisieren der Vorderseite der CMOS-Schicht vor dem Bonden des Handhabungswafers umfasst, oder
wobei das Bonden des Handhabungswafermaterials an die Vorderseite der CMOS-Schicht durch eine Oxid-an-Oxid-Bindung erfolgt.

7. Verfahren nach Anspruch 1, wobei die epitaxiale Schicht auf eine Dicke von 4 µm bis 20 µm abgeschieden wird.

8. Direktdetektor zur Bildgebung von ionisierender Strahlung, wobei der Detektor umfasst:
einen monolithischen aktiven Pixelsensor, der eine epitaxiale Siliziumschicht (920), die auf einem Siliziumsubstrat angeordnet ist, und eine CMOS-Schicht (930), die auf der epitaxialen Siliziumschicht angeordnet ist, aufweist; und
einen Handhabungswafer (950), der an eine Vorderseite der CMOS-Schicht gebondet ist,
wobei das Siliziumsubstrat bis hinab zu einer Rückseite der epitaxialen Siliziumschicht entfernt wurde,
**dadurch gekennzeichnet, dass**
eine erste Sektion des Handhabungswafers selektiv von einer Region, die dem Pixelsensor entspricht, so entfernt wurde, dass eine zweite Sektion des Handhabungswafers an einem Umfangsrand des Pixelsensors verbleibt, und
der Direktdetektor so eingerichtet ist, dass die ionisierende Strahlung nur von der Rückseite der epitaxialen Siliziumschicht her eintritt.

9. Direktdetektor nach Anspruch 8, wobei die epitaxiale Schicht eine Dicke von etwa 4 µm bis 20 µm aufweist.

10. Direktdetektor nach Anspruch 8, wobei der monolithische aktive Pixelsensor des Weiteren aufweist:
eine Verarmungsregion in der epitaxialen Siliziumschicht,
eine Fotodiode in der Verarmungsregion,
eine gepinnte Schicht auf der Fotodiode, und
eine potenzialfreie Diffusionsregion in der epitaxialen Siliziumschicht.

11. Direktdetektor nach Anspruch 10,
wobei die epitaxiale Schicht eine Siliziumschicht vom p-Typ ist,
wobei die Fotodiode eine Fotodiode vom n-Typ ist, die in eine Verarmungsregion eingebettet ist,
wobei die gepinnte Schicht Silizium vom p++-Typ ist, und
wobei die potenzialfreie Diffusionsregion ein Siliziummaterial vom n-Typ ist.

12. Direktdetektor nach Anspruch 10, wobei die CMOS-Schicht aufweist:
eine Metallisierungsstruktur auf der Vorderseite der CMOS-Schicht, die einen Fotodiodenkontakt, einen potenzialfreien Diffusionsregionskontakt und einen Gate-Kontakt aufweist, und
eine Ausleseschaltung, die mit dem potenzialfreien Diffusionsregionskontakt verbunden ist.

13. Direktdetektor nach Anspruch 8, wobei der Direktdetektor dazu eingerichtet ist, in einem Transmissionselektronenmikroskop mit einer solchen Ausrichtung montiert zu werden, dass die ionisierende Strahlung von der Rückseite der epitaxialen Siliziumschicht her in den Detektor eintritt.

14. Verfahren zum Detektieren von ionisierender Strahlung in einem Transmissionselektronenmikroskop, umfassend:
Bereitstellen eines monolithischen aktiven Pixelsensors, der eine epitaxiale Schicht aufweist, die zwischen einer CMOS-Schicht und einem Siliziumsubstrat angeordnet ist, wobei der monolithische aktive Detektor des Weiteren einen Handhabungswafer aufweist, der an eine Vorderseite der CMOS-Schicht gebondet ist, wobei das Siliziumsubstrat entfernt wurde, um eine Rückseite der epitaxialen Siliziumschicht freizulegen, und wobei eine erste Sektion des Handhabungswafers selektiv von einer Sensorregion der CMOS-Schicht entfernt wurde, während eine zweite Sektion des Handhabungswafers um einen Umfang der Sensorregion herum belassen wurde, wobei der Detektor so eingerichtet ist, dass die ionisierende Strahlung von der Rückseite der epitaxialen Siliziumschicht her eintritt;
Montieren des Detektors in dem Transmissionselektronenmikroskop;
Ausrichten des Detektors so, dass die ionisierende Strahlung von der Rückseite der epitaxialen Siliziumschicht her in den Detektor eintritt; und
Auslesen von Signalen aus dem Detektor, die die ionisierende Strahlung repräsentieren.

15. Verfahren nach Anspruch 14,
wobei die ionisierende Strahlung Elektronen mit einer Energie von 40 keV bis 120 keV ist, oder
wobei die ionisierende Strahlung Elektronen mit einer Energie von 0 keV bis 100 keV ist, oder
wobei die ionisierende Strahlung Elektronen mit einer Energie von 0 keV bis 300 keV ist, oder
wobei die ionisierende Strahlung Elektronen mit einer Energie von 0 keV bis 30 keV ist, oder
wobei die ionisierende Strahlung Elektronen mit einer Energie von 100 keV ist.

## Revendications

1. Procédé de formation d'un détecteur direct pour l'imagerie d'un rayonnement ionisant dans un microscope électronique à transmission, comprenant de :
former un capteur monolithique de pixels actifs dans un processus à capteur d'image CMOS, dans lequel le capteur comporte une couche de silicium épitaxiale (520) disposée sur un substrat de silicium (510) et une couche CMOS (530) disposée sur la couche de silicium épitaxiale ;
lier un matériau de plaquette de manipulation à une face avant de la couche CMOS (650) ;
et
retirer le substrat de silicium pour révéler une face arrière de la couche de silicium épitaxiale ;
**caractérisé par**
retirer sélectivement une première section du matériau de plaquette de manipulation d'une région de détection de la couche CMOS et laisser une seconde section (852) du matériau de plaquette de manipulation autour d'une périphérie de la région de détection,
dans lequel le détecteur direct est configuré pour être monté dans le microscope électronique à transmission en venant uniquement en contact avec la seconde section, et
dans lequel le détecteur direct est en outre configuré de telle sorte que le rayonnement ionisant entre uniquement depuis la face arrière de la couche de silicium épitaxiale.

2. Procédé selon la revendication 1, comprenant en outre de :
retirer une première partie du substrat de silicium par un procédé de rodage ; et
retirer une partie restante du substrat de silicium par gravure chimique.

3. Procédé selon la revendication 1, comprenant en outre de :
retirer la première section de la plaquette de manipulation par gravure chimique sélective.

4. Procédé selon la revendication 1, comprenant en outre de : former une photodiode dans la couche de silicium épitaxiale ; et former une région de diffusion libre de potentiel dans la couche de silicium épitaxiale.

5. Procédé selon la revendication 4, comprenant en outre de :
former un motif de métallisation sur la couche CMOS qui comporte un contact de photodiode, un contact de diffusion libre de potentiel et un contact de grille ; et
connecter le contact de diffusion libre de potentiel à un circuit de lecture.

6. Procédé selon la revendication 1,
dans lequel le procédé comprend en outre la planarisation de la face avant de la couche CMOS avant de lier la plaquette de manipulation, ou
dans lequel la liaison du matériau de plaquette de manipulation à la face avant de la couche CMOS s'effectue par une liaison oxyde à oxyde.

7. Procédé selon la revendication 1, dans lequel la couche épitaxiale est disposée jusqu'à une épaisseur de 4 µm à 20 µm.

8. Détecteur direct pour l'imagerie d'un rayonnement ionisant, le détecteur comprenant :
un capteur monolithique à pixels actifs comportant une couche de silicium épitaxiale (920) disposée sur un substrat de silicium et une couche CMOS (930) disposée sur la couche de silicium épitaxiale ; et
une plaquette de manipulation (950) liée à une face avant de la couche CMOS,
dans lequel le substrat de silicium a été retiré jusqu'à une face arrière de la couche de silicium épitaxiale,
**caractérisé en ce que**
une première section de la plaquette de manipulation a été sélectivement retirée d'une région correspondant au capteur de pixels, en laissant une seconde section de la plaquette de manipulation sur une périphérie du capteur de pixels, et
le détecteur direct est configuré de telle sorte que le rayonnement ionisant entre à partir de la face arrière de la couche de silicium épitaxiale.

9. Détecteur direct selon la revendication 8, dans lequel la couche épitaxiale a approximativement 4 µm à 20 µm d'épaisseur.

10. Détecteur direct selon la revendication 8, dans lequel le capteur monolithique à pixels actifs comporte en outre :
une région déplétion dans la couche de silicium épitaxiale,
une photodiode dans la région de déplétion,
une couche d'ancrage sur la photodiode, et
une région de diffusion libre de potentiel dans la couche de silicium épitaxiale.

11. Détecteur direct selon la revendication 10,
dans lequel la couche épitaxiale est une couche de silicium de type p,
dans lequel la photodiode est une photodiode de type n incorporée dans une région de déplétion,
dans lequel la couche d'ancrage est du silicium de type p⁺⁺, et
dans lequel la région de diffusion libre de potentiel est une matière de silicium de type n.

12. Détecteur direct selon la revendication 10, dans lequel la couche CMOS comporte :
un motif de métallisation sur la face avant de la couche CMOS, comportant un contact de photodiode, un contact de région de diffusion libre de potentiel et un contact de grille, et
un circuit de lecture connecté au contact de région de diffusion libre de potentiel.

13. Détecteur direct selon la revendication 8, dans lequel le détecteur direct est configuré pour être monté dans un microscope électronique à transmission avec une orientation telle que le rayonnement ionisant entre dans le détecteur à partir de la face arrière de la couche de silicium épitaxiale.

14. Procédé de détection d'un rayonnement ionisant dans un microscope électronique à transmission, comprenant de :
mettre à disposition un capteur monolithique à pixels actifs qui comporte une couche épitaxiale disposée entre une couche CMOS et un substrat de silicium, le détecteur monolithique actif comportant en outre une plaquette de manipulation liée à une face avant de la couche CMOS, dans lequel le substrat de silicium a été retiré pour révéler une face arrière de la couche de silicium épitaxiale, et dans lequel une première section de la plaquette de manipulation a été sélectivement retirée d'une région de détection de la couche CMOS tout en laissant une seconde section de la plaquette de manipulation autour d'une périphérie de la région de détection, dans lequel le détecteur est configuré de telle sorte que le rayonnement ionisant entre à partir de la face arrière de la couche de silicium épitaxiale ;
monter le détecteur dans le microscope électronique à transmission ;
orienter le détecteur de sorte que le rayonnement ionisant entre dans le détecteur à partir de la face arrière de la couche de silicium épitaxiale ; et
lire des signaux provenant du détecteur représentant le rayonnement ionisant.

15. Procédé selon la revendication 14,
dans lequel le rayonnement ionisant est constitué d'électrons ayant une énergie de 40 keV à 120 keV, ou
dans lequel le rayonnement ionisant est constitué d'électrons ayant une énergie de 0 keV à 100 keV, ou
dans lequel le rayonnement ionisant est constitué d'électrons ayant une énergie de 0 keV à 300 keV, ou
dans lequel le rayonnement ionisant est constitué d'électrons ayant une énergie de 0 keV à 30 keV, ou
dans lequel le rayonnement ionisant est constitué d'électrons ayant une énergie de 100 keV.
